(19) **Europäisches Patentamt European Patent Office Office européen des brevets**

(11) **EP 1 204 134 B1**

(12) **EUROPEAN PATENT SPECIFICATION**

(45) Date of publication and mention of the grant of the patent:
**24.10.2007 Bulletin 2007/43**

(51) Int Cl.:
*H01J 37/32* *(2006.01)*

(21) Application number: **02075355.4**

(22) Date of filing: **09.06.1997**

(54) **RF plasma processor**

RF Plasmabearbeitungsvorrichtung

Dispositif de traitement par plasma rf

(84) Designated Contracting States:
**CH DE ES FI FR GB IE IT LI NL SE**

(30) Priority: **10.06.1996 US 662732**
**10.06.1996 US 661203**

(43) Date of publication of application:
**08.05.2002 Bulletin 2002/19**

(62) Document number(s) of the earlier application(s) in accordance with Art. 76 EPC:
**97303962.1 / 0 813 227**

(73) Proprietor: **LAM RESEARCH CORPORATION**
**Fremont, CA 94538-6470 (US)**

(72) Inventors:
• **Holland, John P.**
**Santa Clara, CA 95050 (US)**
• **Barnes, Michael S.**
**San Francisco, CA 94147 (US)**

(74) Representative: **W.P. Thompson & Co.**
**55 Drury Lane**
**London WC2B 5SQ (GB)**

(56) References cited:
**EP-A- 0 413 282        EP-A- 0 710 055**
**US-A- 5 401 350**

**Description**

The present invention relates generally to radio frequency (r.f.) vacuum plasma processors and more particularly to such a processor including a plural turn excitation coil having radially displaced arcuate segments with a geometry relative to a wavelength of an exciting r.f. source such that distributed r.f. currents and voltages in the coil are combined to produce an electromagnetic field that causes a substantially uniform spatial plasma flux to be produced on a processed workpiece.

Various structures have been developed to supply r.f. fields from devices outside of a vacuum chamber to excite a gas in a plasma processor to a plasma state. The r.f. fields have been derived from electric field sources including capacitive electrodes, electromagnetic field sources including electron cyclotron resonators, and induction, *i.e.*, magnetic, field sources including coils. The excited plasma interacts with a workpiece in the chamber to etch the workpiece or to deposit material on it. The workpiece can be a semiconductor wafer having a planar circular surface or a solid dielectric, *e.g.,* a rectangular glass substrate used in flat panel displays, or a metal plate.

A processor for treating workpieces with an inductively coupled planar plasma (ICPP) source is disclosed, *inter alia*, by Ogle, U.S. Patent 4,948,458, commonly assigned with the present invention. In Ogle, the magnetic field that excites the plasma is derived from a planar coil positioned on or adjacent to a single planar dielectric window that extends in a direction generally parallel to the workpiece planar surface being processed. The coil is connected to be responsive to an r.f. source having a frequency in the range of 1 to 100 MHz (typically 13.56 MHz) and coupled to the coil by an impedance matching network. The coil is configured as a planar linear spiral having external and internal terminals connected to be responsive to the r.f. source. Coultas et al., U.S. Patent 5,304,279 discloses a similar device employing plasma confinement using permanent magnets in combination with the planar spiral coil.

Cuomo et al., U.S. Patent 5,433,812 and Ogle, U.S. Patent 5,277,751 disclose variations of the aforementioned processors wherein the planar spiral coil is replaced by a solenoidal coil. The solenoidal coil is wound on a dielectric mandrel or the like and includes plural helical-like turns, a portion of which extend along the dielectric window surface. The remainder of the coil extends above the dielectric window. Opposite ends of the solenoidal coil are connected to an r.f. excitation source.

These inductive sources excite the plasma by heating electrons in the plasma region near the vacuum side of the dielectric window by oscillating inductive fields produced by the coil and coupled through the dielectric window. Inductive currents which heat the plasma electrons are derived from the r.f. magnetic fields produced by r.f. currents in the planar coil. The spatial distribution of the magnetic field is a function of the sum of the fields produced by each of the turns of the coil. The field produced by each of the turns is a function of the magnitude of r.f. current in each turn. For the spiral design disclosed by the Ogle '458 patent, the r.f. currents in the spiral coil are distributed to produce a ring shaped region where power is absorbed by the plasma. The ring shaped region abuts the vacuum side of the dielectric window. At low pressures, in the 1.0 to 10 mTorr range (1 m Torr = 0,133 Pa), diffusion of the plasma from the ring shaped region produces a plasma density peak in a central portion of the chamber, along a chamber center line away from the window. At intermediate pressure ranges, in the 10 to 100 mTorr range, gas phase collisions of electrons, ions, and neutrons in the plasma prevent substantial diffusion of the plasma charged particles outside of the annular region. As a result there is a relatively high plasma flux in a ring like region of the workpiece but low plasma fluxes in the center and peripheral workpiece portions. Hence, there are substantially large plasma flux variations between the ring and the volumes inside and outside of the ring.

Chen et al., U.S. Patent 5,226,967 considers the adverse effects of reduced plasma density at radial regions removed from the center of a planar spiral coil. In Chen '967, the strength of magnetic fields generated by the planar coil and coupled to the plasma decreases along the chamber center line. The decrease is provided by increasing the thickness of the dielectric window center portion, relative to the thickness of other regions of the window. At pressures up to about 20 mTorr, the increased thickness of the solid dielectric material extending into the plasma shifts the ring shaped region for r.f. power absorption to a larger radius. The shift of the ring shaped region position changes the diffusion characteristics of this plasma generation region so diffusion is more uniform across the entire processed substrate surface diameter, particularly at the peripheral portion of the substrate.

In the device of the ' 967 patent, an electromagnetic shield that supports the dielectric window decreases the plasma flux close to the center of the coil. This plasma flux density reduction occurs because the shield decreases coupling between the coil and an electromagnetic field resulting from the r.f. current applied to the coil. The magnetic fields produced by the largest diameter turn of the planar source frequently induce r.f. currents in the electromagnetic shield which supports the window, if the shield and largest turn are sufficiently close to each other. Power coupled to the shield results in (1) a decrease in the coupling efficiency of the r.f. excitation of the plasma and (2) a shift of the ring shaped power absorption region to a smaller diameter region since the magnetic field produced by the largest diameter turn of the coil does not couple as much magnetic flux to the plasma as the inner turns. Substantial uniformity up to about 20 mTorr occurs as a result of diffusion of charged particles into the region below the center of the coil, where the window is thickest. However, as pressure increases above about 20 mTorr, where charged particular diffusion decreases appreciably, the plasma flux beneath the center of the coil, where the r.f. excitation is small, decreases relative to the flux in the other regions beneath the coil. Hence, there is non-uniform plasma flux on different portions of the workpiece.

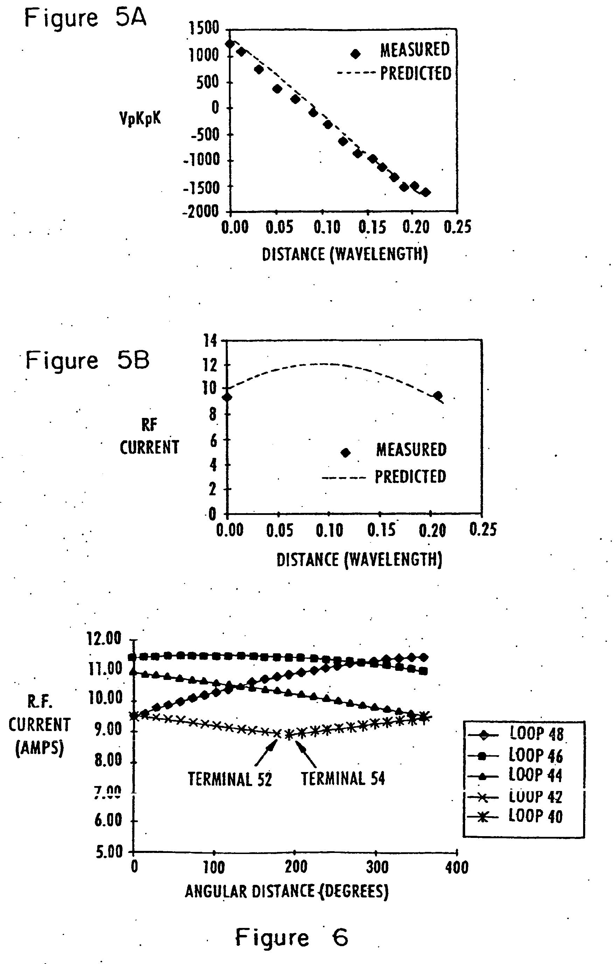

The ring shaped region over which a planar coil couples r.f. power to the plasma can be shifted to larger diameters by removing the inner turns of the planar spiral. Fukusawa et al. in an article entitled "RF Self-Bias Characteristics in Inductively Coupled Plasma," Japanese Journal of Applied Physics, Vol. 32 (1993), pages 6076-6079, Part 1, No. 12(B), December 1993, discloses a single turn planar spiral coil for exciting gases in a plasma processor to a plasma condition. The disclosed coil has inner and outer dimensions of 120 and 160 mm and is 0.5 mm thick and is located in the vicinity of the periphery of a dielectric plate which serves as the top of the vacuum vessel. The ostensible purpose of the one turn coil is to produce a uniform plasma density radial distribution. However, as illustrated in Fig. 6 of Fukusawa et al., the plasma density is not particularly uniform even at a relatively low plasma processor pressure of 10 milliTorr, particularly for the types of r.f. excitation power which are required for plasma etching, in the 1 kilowatt range. For 1 kilowatt r.f. excitation of the single turn source, disclosed by Fukusawa et al., the plasma produces a substantial plasma density peak (of $7.5 \times 10^{11}$ ions $cm^{-3}$), at a position approximately 4.0 centimeters from the center of the chamber. This peak occurs only on one side of the center axis, creating a significant non-radial asymmetry in the spatial distribution of the plasma. The one-turn spiral disclosed by Fukusawa et al. results in a shift in the coupling region to a larger diameter relative to the full spiral disclosed by Ogle in the '458 patent. The Fukusawa et al. devices also' exhibit a nonradial asymmetry which equals or exceeds the radial nonuniformity in the spatial distribution of the plasma density generated by a full spiral. The range of pressures over which the one turn coil can be operated is also limited since this coil relies on diffusion to shift plasma from the ring shaped plasma generation region near the periphery of the chamber to the center of the chamber. At pressures above 10 milliTorr, collisions of charged and uncharged particles in the plasma result in a severe decrease in plasma density in the center region of the chamber.

Ogle, U.S. Patent 4,948,458, also discloses an alternate configuration for the planar coil, comprising a series of concentric loops, where each succeeding loop is connected by a straight lead which extends in only radial direction. Such a radial lead, however, requires a right angle bend in conductors carrying relatively large r.f. currents and is disadvantageous because it causes a very abrupt change in the r.f. current path. The abrupt current path change has a tendency to produce a large magnetic field, which could have an adverse effect on the uniformity of the magnetic fields and plasma flux in the chamber.

In accordance with the present invention, there is a provided a vacuum plasma processor as defined in claim 1.

The coil has sufficient length at the frequency (i.e., the wavelength) of the r.f. source to generate a significant standing wave pattern along the length of the coil due to transmission line effects. Because of the transmission line effects at least one r.f. current maximum exists in the coil at some point along the geometric length of the coil. The magnetic flux (which in turn generates the induction field for exciting the plasma) produced by each coil segment is proportional to the magnitude of the r.f. current occurring in the segment. As a result, a single loop connected to an r.f. supply is expected to produce a nonradial maximum in the plasma density at a position corresponding to the location of the coil r.f. current maximum. This type of nonradial maximum is seen in the Fukusawa et al. data. For a coil with plural ring segments, the plasma density spatial distribution is a function of both the geometries of the segments and the level of r.f. current occurring in each segment. For the multiple element spiral coil disclosed by the Ogle '458 patent, the spatial average of the magnetic flux produces a plasma with ring shaped plasma generation region near the center of the vacuum side of the dielectric window. Only a small degree of nonradial asymmetry is produced by the r.f. current maximum occurring in one portion of the spiral.

In the improved planar coil to be described below, the interior and exterior coil segments are positioned and arranged so the magnetic fluxes from different regions of at least some pairs of adjacent coil turns are additive. Because these different regions are adjacent each other, the magnetic fluxes from them add and average to a value which produces a uniform plasma flux across the workpiece processed surface. The elements of the coil are arranged to produce a greater degree of magnetic flux from the outer turns relative to the magnetic flux produced by the inner turns. By providing maximum magnetic flux in the outer turns and minimum flux in the smaller diameter, inner turns, the outer diameter of the ring shaped plasma generation region is extended. The proper choice of diameter size for each of these segments results in a planar coil which produces a plasma generation region which diffuses to and uniformly interacts with the workpiece processed surface. The diameters of these ring segments are arranged to produce this uniform flux across the workpiece processed surface over a wider range of operating pressures, typically from 1 milliTorr to 100 milliTorr.

The production of a uniform plasma flux on the workpiece processed surface requires correct selection of the aspect ratio of the chamber, *i.e.,* the ratio of cylindrical chamber diameter to the distance between the workpiece processed surface and the bottom of the dielectric plate (the top of the chamber). At the correct aspect ratio, the ring shaped plasma at the top of the chamber diffuses to the workpiece surface so there is a spatially uniform plasma flux on the workpiece processed surface.

To this end, in one preferred embodiment, the chamber upper surface above which the coil is mounted consists of only a 37.3 centimeter diameter circular quartz plate window with a uniform thickness of 2 centimeters. The plasma chamber is a cylindrical vessel with a metal wall having a 35.6 centimeter inner diameter. The planar coil outer diameter is about 30.5 centimeters. The resulting approximately 2.5 centimeter gap between the bottom face of the coil and the top face of the chamber (defined by the bottom face of the quartz plate) prevents the magnetic flux in the outermost turn of the coil from being significantly coupled to the metal chamber wall. A metal electromagnetic shield enclosure which surrounds the planar coil is located beyond the chamber wall outer diameter so magnetic flux in the outermost turn of the coil is not significantly coupled to the shield enclosure. The cylindrical shape of the plasma vessel assists in producing a uniform plasma flux on the workpiece processed surface. The spacing of the workpiece from the plasma generation region is optimized to produce a uniform flux on the workpiece processed surface over a wide range of operating pressures. For the coil and chamber diameters listed above, the spacing between the vacuum side of the dielectric plate and the upper, processed workpiece surface is about 12 centimeters.

Because of the transmission line effects of the coil, a spatially averaged r.f. current is produced in the coil to provide uniform plasma excitation over a wide range of operating pressures. The amount of capacitive coupling from the coil to the plasma is sufficiently low that there is no appreciable degradation in the uniformity of plasma flux on the workpiece processed surface. A small amount of capacitive coupling in a predominantly inductively coupled plasma source has been found to be beneficial to the operation of the discharge. Capacitive coupling of the r.f. voltage on the coil to the plasma through the dielectric plate is required to (1) initiate the plasma discharge and (2) stabilize a steady state plasma discharge. This is because the capacitive coupling introduces a small amount of higher energy electrons in the predominantly low energy inductive discharge. To provide this degree of capacitive coupling without degrading the overall coupling of the coil to the plasma, the coil r.f. voltage spatial distribution is optimized. In one embodiment, capacitive coupling optimization is primarily accomplished by exciting the coil so it has capacitive coupling peaks (*i.e.* the points with the highest r.f. voltages) at terminals of the coil in the coil center. These terminals are connected to the r.f. excitation source.

In one embodiment, the coil includes at least one peripheral turn in proximity to the shield and at least one further turn inside the peripheral turn. The coil has a geometry such that magnetic flux derived from a center region of the area circumscribed by the coil is substantially less than magnetic flux derived from the coil in a region outside of the center region. Preferably in this embodiment, the coil includes plural turns, all in proximity to the shield and removed from the center of the window.

The coil is connected to the source by first and second terminals at diametrically opposite sides thereof and includes only two turns (*i.e.* first and second turns) in proximity to the shield and removed from the center of the window. In one embodiment, the turns have circular patterns concentric with the center of the window. Each of the first and second turns has first and second closely spaced ends The first ends of the first and second turns are respectively at the first and second terminals, while the second ends of the first and second turns are electrically connected together.

One of the concentric turns is a peripheral turn and another of the turns is interior to all other turns. Each of the turns has first and second closely spaced ends such that the first end of the peripheral turn is at the first terminal and the first end of the turn interior to all other turns is at the second terminal. The turns have the remaining ends thereof connected together so the turns are connected in series with each other as a result of the second end of the peripheral turn being connected to a terminal of an interior turn next to the peripheral turn and the second end of the turn interior to all the other turns being connected to an end of the turn next to the turn interior to all other turns.

In certain instances the coil is arranged to have a lower electromagnetic field coupling coefficient to the plasma at the region of maximum current than at the region of minimum current. This result can be attained by arranging the coil to have a smaller self inductance at the region of maximum current than at the region of minimum current. Alternatively, the coil is arranged so it is farther from the workpiece at the region of maximum current than at the region of minimum current. Specifically, the coil is arranged so it is at a greater height above a plane of the workpiece at the region of maximum current than at the region of minimum current.

The following description and drawings disclose, by means of an example, the invention which is characterised in the appended claims, whose terms determine the extent of the protection conferred hereby.

In the drawings:-

Fig. 1 is a schematic diagram of a vacuum plasma processor of the type employed with the present invention;

Figs. 2A and 2B are respectively top and perspective views of a preferred embodiment of a planar coil included in the processor of Fig. 1, wherein the coil includes a split center portion, a set of ring elements near the periphery of the coil and a third ring element at an intermediate diameter;

Fig. 3 is a plot of the spatial variations in the etch rate for a 200 mm wafer processed in the chamber of Fig. 1 by using the planar coil of Figs. 2A and 2B;

Fig. 4 are plots of the measured ion density uniformity produced by the coil of Figs. 2A and 2B measured at a region near the surface of the workpiece for operating pressures between 2.0 and 30 milliTorr (1 m Torr = 0,133 Pa);

Figs. 5A and 5B are plots of the measured and calculated r.f. voltages and currents respectively occurring in the planar coil of Figs. 2A and 2B during excitation of the plasma in the chamber of Fig. 1;

Fig. 6 is a plot of the calculated r.f. currents occurring on each segment of the planar coil of Figs. 2A and 2B as a function of angular distance measured in the plane of the coil;

Fig. 7 is a top view of another planar coil for use in the processor of Fig. 1, wherein the coil includes two electrically parallel segments having a common center connection and diametrically opposed peripheral connections to an r.f. source;

Fig. 8 is a top view of a planar coil having three electrically parallel segments, each having a center connection and three peripheral r.f. excitation source connections, each spaced approximately 120° apart;

Fig. 9 is a top view of a planar coil having four electrically parallel segments, each having a center connection and four peripheral r.f. excitation source connections spaced 90° from each other;

Fig. 10 is a top view of a planar coil having a peripheral segment electrically in series with two parallel interior segments;

Fig. 11 is a top view of a planar coil including two circular peripheral portions;

Fig. 12 is a top view of a planar coil having three circular peripheral portions;

Fig. 13 is a top view of a planar spiral coil having no turns in the center thereof;

Fig. 14 is a plot of plasma flux resulting from plasma excitation by any of the coils illustrated in Figs. 7-13 when the coils are positioned in a plane parallel to a window of the vacuum plasma processor of Fig. 1;

Fig. 15 is a perspective view of a planar coil tilted with respect to a dielectric window of the plasma processor of Fig. 1; and

Fig. 16 is a top view of a coil having differing self-inductance values along its length by virtue of the coil having differing cross sectional areas.

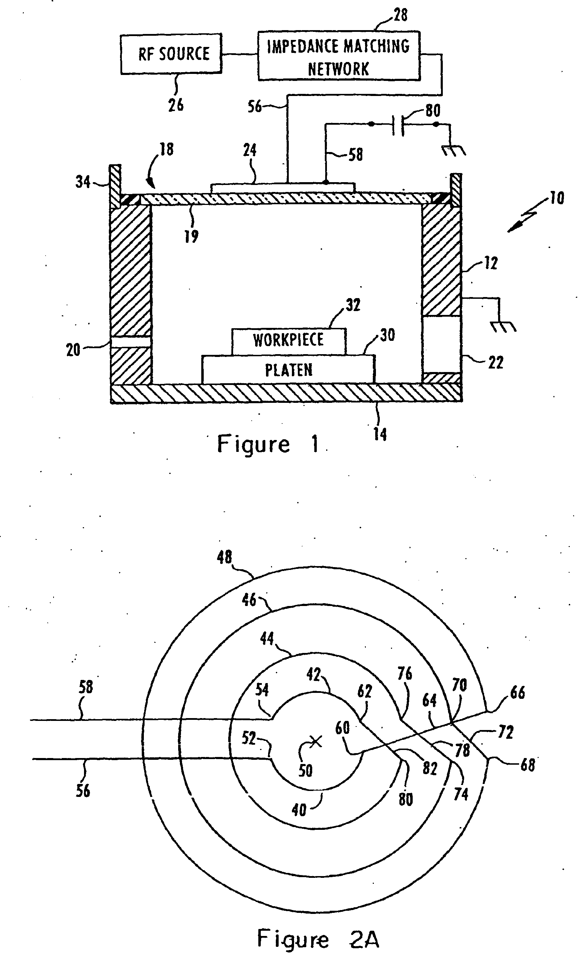

Reference is now made to Fig. 1 of the drawing, wherein a plasma workpiece processor that can be used for etching a semiconductor, dielectric or metal substrate or for depositing molecules on the substrate is illustrated as including vacuum chamber 10, shaped as a cylinder having grounded metal wall 12, metal bottom end plate 14, and a circular top plate structure 18, consisting of a dielectric window structure 19, having the same thickness from its center to its periphery. Sealing of the vacuum chamber 10 is provided by conventional gaskets (not shown).

A suitable gas that can be excited to a plasma state is supplied to the interior of chamber 10 from a gas source (not shown) via port 20 in side wall 12. The interior of the chamber is maintained in a vacuum condition-, at a pressure that can vary in the range of 1-100 milliTorr, by a vacuum pump (not shown), connected to port 22 in the side wall 12. Alternatively, port 22 is located in the end plate 14. The gas in the chamber is excited to a spatially uniform plasma state by a suitable electric source. The electric source includes a substantially planar coil 24, usually mounted immediately above window 19 and excited by r.f. power source 26 via impedance matching network 28. Typically, r.f. source 26 has a frequency of 13.56 MHz. Workpiece 32 is fixedly mounted in chamber 10 to the surface of a substrate platen 30 which is parallel to the surface of window 19. Workpiece 32 is electrostatically clamped to the surface of substrate platen 30 by use of a DC potential provided by a DC power supply (not shown).

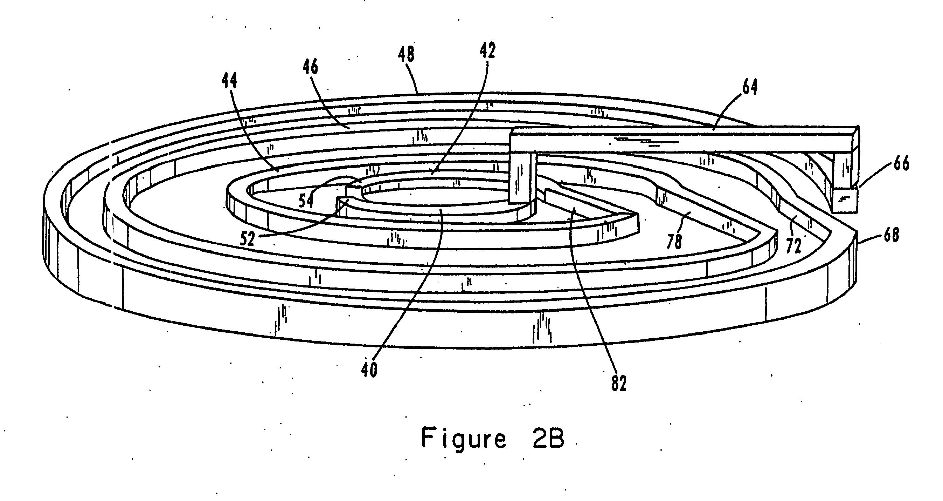

Surrounding planar coil 24 and extending above top end plate 18 is a metal tube or can-like shield 34, providing electromagnetic decoupling of the fields originating in coil 24 from the surrounding environment. In the embodiment of Figs. 2A and 2B, the distance between shield 34 and the peripheral regions of coil 24 is large enough to prevent significant absorption by shield 34 of the magnetic fields generated by the peripheral regions of coil 24.

The diameter of cylindrically shaped chamber 10 is large enough to prevent the absorption by chamber walls 12 of the magnetic fields generated by the peripheral regions of coil 24. The diameter of dielectric window structure 19 is greater than the diameter of chamber 10 such that the entire upper surface of chamber 10 is comprised of dielectric window structure 19. The distance between the treated surface of workpiece 32 and the bottom surface of dielectric window structure 19 is chosen to provide the most uniform plasma flux on the exposed, processed surface of the workpiece. For one preferred embodiment of the invention as illustrated in Figs. 2A and 2B, the distance between the workpiece processed surface and the bottom of the dielectric window is approximately 0.3 to 0.4 times the diameter of chamber 10.

The frequency of r.f. source 26 and the length of planar coil 24 between end terminals thereof connected to the source are such that the behavior of the r.f. voltages and currents occurring in the coil can be approximated using r.f. transmission line theory. The transmission line effects occur in the planar coil since each small section of the planar coil, in combination with the dielectric surrounding it, has a finite nonzero capacitance to the plasma. Hence each coil section forms an electrical device represented by distributed inductance and distributed capacitance along the length of the coil. The characteristic impedance of the transmission line formed by the planar coil is a function of the dimensions and shape, *i.e.*, geometry, of the cross section of the conductive material which forms the planar coil, as well as the dielectric constant and thickness of the window material.

The behavior of the planar coil as a transmission line produces a standing wave pattern along the length of the coil which results in variations in the magnitude of the r.f. voltages and currents along the length of the coil. The dependence of the magnetic flux generated by the coil on the magnitude of these r.f. currents results in differing amounts of plasma being produced in different portions of chamber 10 beneath different portions of the coil. As a result, to derive a uniform plasma using a planar coil requires the variations in the r.f. current magnitude flowing in different parts of the coil to be spatially averaged. Spatially averaging these different current values in the different parts of the coil substantially prevents nonradial asymmetries in the plasma density, particularly at regions of high r.f. current in coil segments near the periphery of coil 24. The transmission line behavior of the r.f. current in planar coil 24 increases the amount of magnetic flux generated by the peripheral coil segments relative to the center coil segments. This result is achieved by exciting coil 24 with r.f. so the regions of maximum r.f. current are on the peripheral coil segments.

In the preferred embodiment illustrated in Figs. 2A and 2B, planar coil 24 includes interior substantially semicircular loops 40 and 42 and peripheral substantially circular segments 46 and 48 and an intermediate substantially circular segment 44. Loops 40 and 42'form half turns of coil 24, while each of loops 44, 46 and 48 forms almost a complete full turn; the full and half turns are connected in series with each other. All of segments 40, 42, 44, 46 and 48 are coaxial with central coil axis 50, coincident with the center axis of chamber 10. Opposite excitation terminals 52 and 54, in the center portion of coil 24, are respectively coupled by leads 58 and 56 to opposite terminals of r.f. source 26 via matching network 28 and one electrode of capacitor 80, the other electrode of which is grounded. Terminal 60, at the end of segment 40 opposite from terminal 52, is connected to end terminal 66 of outer loop segment 48 by conductive strap 64 which is located in a region slightly above the plane of coil 24 and does not touch any of the coil segments which run beneath it so the strap is electrically insulated from coil 24, except at terminals 60 and 66. Segment 48 has a second terminal 68 slightly less than 360° from terminal 66; terminal 68 is connected to terminal 70 of loop segment 46 via strap 72. Loop 46, having an angular extent of almost 360°, has a second end terminal 74 connected to terminal 76 of loop 44 via strap 78. Loop 44, having an angular extent of almost 360°, has a second end terminal 80 which is connected by strap 82 to terminal 62, at the end of segment 42 opposite from terminal 54.

The dimensions of substantially circular loop segments 44, 46 and 48 are determined by the wavelength of the r.f. voltage and current supplied by source 26 to coil 24 and by the dimensions of the workpiece. The wavelength of the r.f. in the coil is some fraction (typically 0.5-0.7) of the free space wavelength. In the preferred embodiment of coil 24, the diameter of workpiece 32 is less than the diameter of circular loop 46 but greater than the diameter of circular loop 44. In the preferred embodiment, the outermost loop segment 48 has a diameter approximately 0.0248 times the wavelength of the r.f. voltage and current in the coil. The diameter of loop segment 46 is approximately 0.0207 times this wavelength and the diameter of loop segment 44 is approximately 0.0146 times this wavelength The equal radii of the semicircular ring segments 40 and 42 are approximately 0.00413 times the wavelength. The effective transmission line lengths for loop segments 48, 46, 44, 40 and 42 are respectively approximately 0.078, 0.065, 0.046, 0.013 and 0.013 times the wavelength of the r.f. current in the coil, so the total coil length is approximately 0.22 times the wavelength.

Capacitor 80, having a capacitive impedance, $Z_{cap} = 1/(j2\pi fC)$, where $j = \sqrt{-1}$, f is the frequency of r.f. source 26, and C is the capacitance of capacitor 30, shifts the phase and therefore location of the voltage and current distribution across the entire length of coil 24. The voltage and current distribution are shifted in coil 24 so the coil produces r.f. electric and magnetic fields which provide uniform plasma flux on the processed surface of workpiece 32. For the preferred embodiment, the voltage and current of coil 24 are distributed by selecting the value of capacitor 80 so the peak-to-peak r.f. current at coil terminal 54 is a minimum and equals the peak-to-peak r.f. current at coil terminal 52. At this condition, the coil has opposite polarity maximum peak-to-peak r.f. voltages at terminals 52 and 54 and the coil maximum r.f. current occurs near conductive strap 72. The distribution of r.f. voltages and currents in the coil can be approximated by

$$V_{pkpk}(X) = V^{\circ}_{pkpk} \cos [\beta(x+x^{\circ})] \qquad (1)$$

and

$$I_{pkpk}(X) = I^{\circ}_{pkpk} \sin [\beta(x+x^{\circ})], \qquad (2)$$

where:

x is the linear distance measured from input terminal 54 of the coil,

β is the angular frequency of r.f. source 26 (i.e. 2πf) divided by c, the speed of light,

x° is an offset from zero which is determined by the value of the capacitor 80, and

$V^{\circ}_{pkpk}$ and $I^{\circ}_{pkpk}$ are respectively the maximum r.f. peak-to-peak voltages and currents supplied to the coil. For the preferred embodiment of the coil, the value of capacitor 80 is selected so x° is approximately 0.15 to 0.16 times the wavelength $(\lambda = \frac{c}{f})$ of the r.f. current flowing in the coil. The distribution of the calculated and measured r.f. voltages and currents for the preferred embodiments of coil 24 are respectively shown in Figs. 5A and SB as a function of the length of the coil.

The magnetic flux produced by the peripheral regions of coil 24 is greater than the magnetic flux generated by the center region of the coil because the magnitude of the peak-to-peak r.f. currents is greater in the peripheral segment of the coil relative to the magnitudes of the peak-to-peak currents of the central segments. In the preferred embodiment, the maximum peak-to-peak r.f. current amplitude occurs in substantially circular loop segment 46. The amplitudes of the peak-to-peak r.f. currents in adjacent loop segments 44 and 48 and in loop segment 46 and the spacing of loop segments 44, 46 and 48 from each other are such that magnetic fluxes from these three loop segments are combined in space to provide a total magnetic flux density, just under window 19, having a maximum value over a relatively broad annular area, extending from between loop segments 46 and 48 to between intermediate segment 44 and interior segments 40 and 42. The total magnetic flux is also relatively constant as a function of an angular coordinate θ.

The angular coordinate, θ, represents the spatial angular displacement about the center axis of chamber 10 in the counter clockwise direction from a phantom line 100. Terminals 60, 80, 74 and 68 are angularly equidistant from and on one side of line 100 while terminals 62, 76, 70 and 66 are angularly equidistant by the same amount from and on the other side of line 100. Hence, *e.g.* coil segment 48 has a spatial angular extent of slightly less than 360° from an angle θ, which is slightly greater than θ = 0°, to an angle $\theta_2$, which is slightly less than θ = 360°; and terminals 52 and 54 are at angles $\theta_3$ and $\theta_4$ respectively slightly greater and slightly less than 180°. A spatially averaged magnetic flux which is constant along a particular coordinate value θ provides a plasma which is radially symmetric along θ. The amplitudes of the peak-to-peak r.f. currents in the two substantially semicircular, equal radius segments 40 and 42 are significantly less than the amplitudes of the currents in the other segments. Segments 40 and 42 derive sufficient magnetic fluxes which are spatially averaged with the magnetic fluxes derived from the other segments 44, 46 and 48 so a substantially uniform plasma flux is generated at the level of the processed surface of workpiece 32 across the diameter of the chamber. The amplitudes of the peak-to-peak r.f. currents in each of the segments are plotted in Fig. 6 as a function of angular distance θ.

From Fig. 6, the highest values of r.f. peak-to-peak current in coil 24 are (1) throughout loop segment 46, (2) the portion of loop segment 48 from terminal 68 (at the connection of segment 48 to segment 46 via strap 72) to an angle $\theta_4$, slightly less than θ = 180°, i.e. for an angular extent of somewhat more than 180°, and (3) in the portion of loop segment 44 from terminal 76 (at the connection of segment 44 to segment 46 via strap 78) to $\theta_4$, *i.e.* for an angular extent of somewhat less than 180°. The lowest currents are at terminals 52 and 54 (where they are equal) and along interior loops 40 and 42. Because of this current distribution, the magnetic flux derived from the interior loop segments 40 and 42 of coil 24 is substantially less than the flux from exterior loop portions 46 and 48 to assist in providing uniform plasma flux on the workpiece.

The electrostatic (*i.e.*, capacitive) coupling of the voltages occurring between different portions of planar coil 24 (for example between portions of loop segments 46 and 48 at the same angular coordinate position $\theta_i$) to the plasma has been found to have an influence on the uniformity of the generated plasma flux. The capacitive coupling of these voltages to the plasma depends on the magnitude of the peak-to-peak voltages occurring in the coil segments, as well as the thickness and dielectric material of window 19 which separates the coil from the plasma. In the preferred embodiment of the coil, the influence of the capacitive currents produced by the r.f. voltages is minimized by causing the highest r.f. peak-to-peak voltages to occur at terminals 52 and 54. Such a result occurs because of the geometry of coil 24 and by proper selection of the value of capacitor 80, connected in series with the coil. Interior equal length and equal radii semicircular segments 40 and 42 are oriented such that terminals 52 and 54 at the ends thereof are on diametrically opposite sides of line 100. Positioning terminals 52 and 54 at these locations minimizes the effect of these high r.f. peak-to-peak voltage points. This is because at any instant of time, the voltages at terminals 52 and 54 are substantially equal to each other in amplitude but have opposite polarity. This causes the effects of the two opposite polarity voltages to approximately cancel in the plasma. Dielectric window 19 is preferably quartz and is approximately 0.8 inches thick to minimize the electrostatic coupling of the r.f. voltages between different parts of coil 24 to the plasma while still providing sufficient coupling of the magnetic fields produced by the coil to the plasma.

R.f. excitation of planar coil 24 produces a substantially planar plasma having a relatively uniform flux completely across substrate 32, frequently shaped as a disc. Regardless of shape, substrate 32 has exterior edge dimensions only somewhat less than the interior dimensions of plasma processor chamber 10. Coil 24 is configured so the density of plasma flux incident on the processed surface of substrate 32 is within ±2.5% of the average plasma density across the substrate. This uniformity is achieved because the magnetic flux in the center portion of coil 24 is less than the magnetic flux derived from the peripheral and intermediate portions of the coil. The geometry and method of r.f. excitation of coil 24 provide a uniform plasma flux on the processed surface of substrate 32 for a range of pressures of 1 to 100 milliTorr.

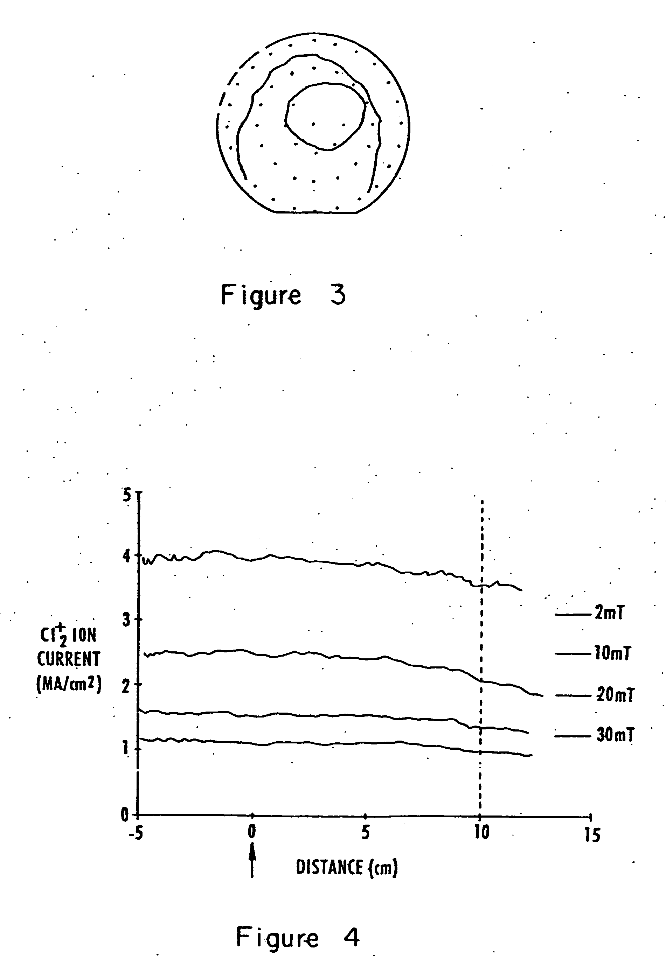

Fig. 3 is a plot of the measured ion current uniformity for the preferred embodiment of the plasma processor chamber 10 measured 1.0 centimeter above the surface of a 200 mm diameter disc shaped substrate for a variety of pressures in the range of 2.0 to 30.0 milliTorr. From Fig. 2, there is a plasma density uniformity within ±2.5% of the average plasma density across the substrate. Fig. 4 is a top view of a plot of the spatial variations in the etch rate for a 200 mm wafer semiconductor etched at 2Pa (15 milliTorr) using the described preferred embodiment of planar coil 24. From Fig. 4, the substrate is etched with a uniformity no less than 2.3%.

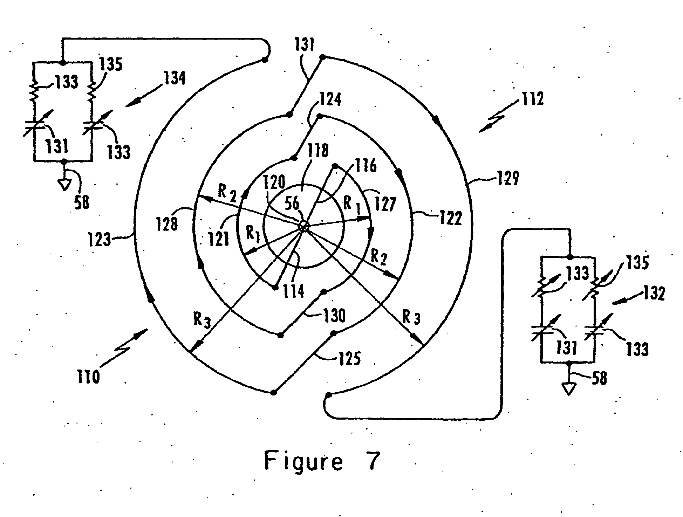

In Figs. 7-13 and 16, the geometries of window 18, coil 24, and shield 34 are such that the coil and shield diameters are closer to each other than in the embodiment of Figs. 2A and 2B, such that the shield absorbs a significant amount of the r.f. energy derived from the coil; particularly from the coil peripheral regions. In each of Figs. 7-13 and 16 at least one terminal of the coil is connected to a reactance. The reactance is selected and the coil length is such that Equations (1) and (2) are satisfied to produce at least one current maximum along the coil length.

The amount of magnetic flux coupled from the peripheral portions of coil 24 to the gas in chamber 10 in proximity to shield 34 and in proximity to side walls 12 thus has a tendency to be lower than the magnetic flux coupled to the remainder of the gas in chamber 10. Thereby, the gas in the interior portion of chamber 10 tends to be excited to a plasma having a considerably higher flux than the flux of the plasma in peripheral portions of the chamber. The plasma flux at the periphery of chamber 10 and proximate the periphery of workpiece 32 tends to be substantially less than the plasma flux toward the center of the chamber and substrate. Hence, etching of the substrate and deposition of material on the substrate has a tendency to be greater in the center portion of the substrate than the peripheral portion thereof. This is particularly the case for high pressure vacuum operation of chamber 10, *i.e.*, pressures between 15 and 60 milliTorr.

In Figs. 7-13 and 16, the planar plasma resulting from r.f. excitation of planar coil 24 is relatively uniform completely across the processed, exposed surface of substrate 32, which has edge dimensions somewhat less than the interior dimensions of plasma processor chamber 10. Coil 24 is configured in Figs. 7-13 and 16 so the density of the plasma incident on the substrate is within about ±2.5% of the average plasma flux across the substrate processed surface. This uniformity is achieved by decreasing, relative to the prior art, the magnetic flux in the center portion of coil 24 in each of the coils of Figs. 7-13 and 16 so the center portion magnetic flux is less than the magnetic flux derived from the peripheral and intermediate portions of the coil. By minimizing the magnetic flux in the center of the coil, the plasma flux across the entire substrate remains substantially uniform. Planar coil 24 in Figs. 7-16 is designed so the magnetic flux derived from portions of the coil where plasma hot spots tend to be developed are minimized.

Reference is now made to Fig. 7 of the drawing, a top view of a version of planar coil 24 including two electrically parallel segments 110 and 112, respectively connected by leads 114 and 116 via lead 56 to terminal 52. The connections of leads 114 and 116 are such that the currents in these leads have very little effect on the plasma in chamber 10. Such a result can be achieved by arranging leads 56, 114 and 116 so they extend at right angles to window 19 and the plane of the coil, or by arranging leads 114 and 116 so they lie parallel to the plane of the coil, but are electrically and magnetically isolated from the coil by interposing metal disc 118 between the coil and leads. Opposite planar faces of disc 118, which respectively contact the coil and leads, are covered by a dielectric coating (not shown) . Lead 56 is connected to a terminal at the center of dielectric coated metal disc 118.

Each of coil segments 110 and 112 includes three substantially semicircular series connected coil portions, each having an arcuate extent of about 175°, and a different radius. The three semicircular portions are connected to each other by two straight leads extending in the radial and somewhat circumferential directions. Thus, coil segment 110 includes coil portions 121, 122 and 123, respectively having radii of $R_1$, $R_2$ and $R_3$ relative to axis 120, and connected together by straight radially and circumferentially extending leads 124 and 125. Coil portions 121 and 123 are on the same first side of substrate center axis 120, while coil portion 122 is on the diametrically opposite second side of the axis. In a similar but opposite manner, coil segment 112 includes semicircular coil portions 127, 128 and 129, respectively having radii of $R_1$, $R_2$ and $R_3$ relative to axis 120 and connected together by straight radially and circumferentially extending leads 130 and 131. Coil portion 128 is diametrically opposed to coil portions 127 and 129, which are on the same side of axis 120 as coil portion 122. The common radius, $R_1$, of coil portions 121 and 127 is slightly greater than the radius of disc 118, so that magnetic flux from semicircular coil portions 121 and 127 is effectively coupled into chamber 10. The values of radii $R_1$, $R_2$ and $R_3$ are comparable to the radius of the substrate being processed by the plasma in chamber 10; for example, if a circular substrate having a 10 cm radius is being processed, the values of $R_1$, $R_2$ and $R_3$ are on the order of 7.5 cm, 10 cm and 12.5 cm.

End points of each of generally semicircular portions 121-123 and 127-129 on a particular side of center axis 120 are substantially aligned and connected to the straight radially and circumferentially extending leads 124, 125, 129 and 130. The spatial arrangement of coil portions 121-130 is such that current flows in the same first direction in those coil portions on one side of axis 120 and in the opposite second direction in the coil portions on the other side of the axis. The ends of exterior or peripheral coil portions 123 and 128 are respectively connected to a terminal connected to lead 58 via appropriate variable impedances 132 and 134. In the illustrated example impedances 132 and 134 are configured as capacitors 131 and 133 respectively connected in series with resistors 133 and 135, although an inductive impedance can be employed. The values of impedances 132 and 134 set the position of the r.f. standing waves which occur in the two portions of the coil, 121-123 and 127-129. The magnitude of the r.f. current occurring at the endpoints of the coil are often set to the same value by properly adjusting the types and values of impedances 132 and 134.

Because of the transmission line properties of parallel coil segments 110 and 112, there are current and voltage maxima and minima in these segments. The current maxima are diametrically opposite from each other in outer coil portions 123 and 128, approximately 30 spatial degrees from the end points of coil segments 110 and 112. Because (1) the current maxima occur in the coil portions in closest proximity to metal can 34, and (2) of the additive effects of the magnetic fluxes from the coil portions, resulting from the current flowing in the coil portions on a particular side of axis 120 flowing in the same direction, and (3) the value of $R_1$ is such that there is minimum magnetic flux in the center of the area circumscribed by the coil, and the magnetic flux coupled to the gas in chamber 10 immediately below the window is lower in the center of the chamber than in the periphery of the chamber. The magnetic flux between the intermediate and peripheral portions of the chamber just below window 19 is relatively uniform. The plasma flux just below window 19 thereby has a tendency to be less than the plasma flux in the peripheral portions of the chamber just below the window. The plasma flux diffuses toward the center of the chamber in regions removed from window 19 and is relatively uniform across the exposed processed surface of substrate 32.

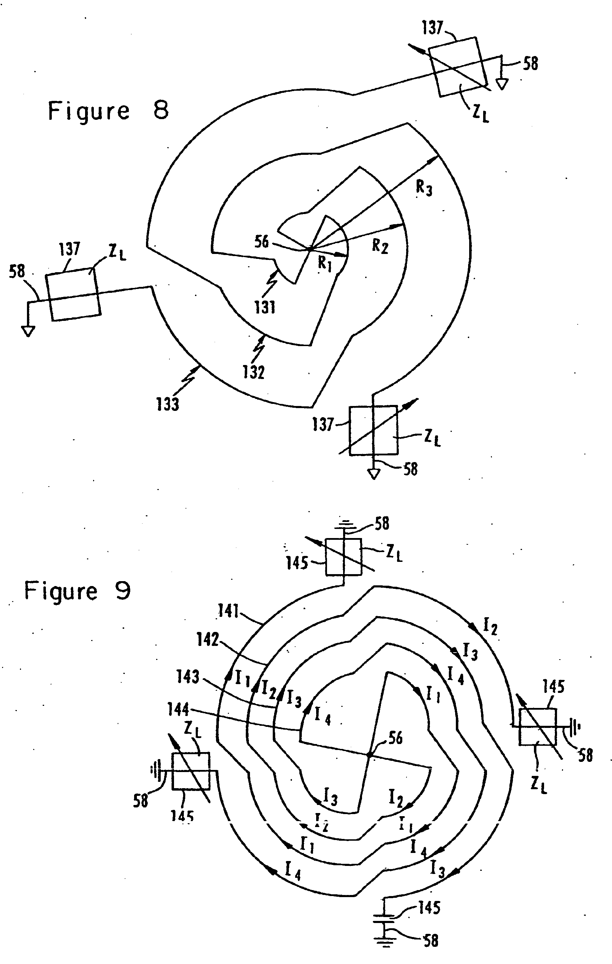

Another parallel coil arrangement, similar to that of Fig. 7, is illustrated in Fig. 8 as including three parallel coil segments 131, 132 and 133, each having one end connected to a terminal connected to lead 56 and a second end connected via variable impedances 137 to terminal 54 via lead 58. Each of impedances 137 is similar to and is adjusted to perform the same functions as impedances 132 and 134, Fig. 7. Each of coil segments 131-133 includes first, second and third arcuately aligned portions, each having an arcuate extent of slightly less than 120°, *i.e.*, about 117°, and two straight radially and circumferentially extending portions. The first, second and third arcuately extending portions respectively have radii of $R_1$, $R_2$ and $R_3$. The geometry of coil segments 131-133 is such that the r.f. currents flow through the aligned arcuate portions in the same direction, to provide an additive magnetic flux relationship and uniformity of plasma flux on the processed substrate. The current maxima in coil segments 131-133 occur in the portions of the coil segments having a radius of $R_3$, approximately 30 spatial degrees from the end points of the coil segments. The magnetic fluxes in the coil segments having a radius $R_3$ is thus greatest, to overcome the tendency for metal can 34 to reduce the magnetic flux coupled into chamber 10.

A preferred parallel configuration, illustrated in Fig. 9, includes four coil segments 141-144, each having a connection to a terminal connected to lead 56 and a connection to a terminal connected to lead 58 via variable impedances 145, each of which is similar to and is adjusted to perform the same function as impedances 132 and 134, Fig. 7. Each of coil segments 141-144 includes four coil portions. Each of the coil portions has an arcuate extent of approximately 90° and a different radius, $R_4$, $R_5$, $R_6$ and $R_7$, respectively, of progressively larger value. The coil portions having radii $R_4$, $R_5$, $R_6$ and $R_7$ are connected together by straight generally radially and circumferentially extending coil portions, which are, for a particular coil segment, displaced 90° of arc from each other. Coil segments 141-144 are such that the straight radially and axially extending segments interconnecting the arcuately extending portions of a particular coil segment are aligned so the longitudinal axes thereof extend parallel to each other.

The geometry of coil segments 141-144 and the connections thereof to the terminals connected to leads 56 and 58 are such that the current flowing in those coil segments in the same quadrant relative to axis 120 is in the same direction. Radius $R_4$ is selected so the magnetic fluxes resulting from currents flowing in the arcuate portions of segments 141-144 have a tendency to cancel each other. This causes a relatively low magnetic flux to be derived in the center of the area circumscribed by the coil. The values of radii $R_5$, $R_6$ and $R_7$, however, are such that the magnetic fluxes resulting from currents flowing in adjacent portions of the same quadrant of coil segments 142-144 are additive to overcome the effect of can 34 on the magnetic field in the periphery of chamber 10. To these ends, the values of $R_4$, $R_5$, $R_6$ and $R_7$ are preferably respectively 30 cm, 25 cm, 15 cm and 4 cm for a 20 cm radius substrate. Current maxima occur in the outer, *i.e.*, peripheral, portions of coil segments 141-144 having radii $R_7$, approximately 30 spatial degrees from the end of each coil segment.

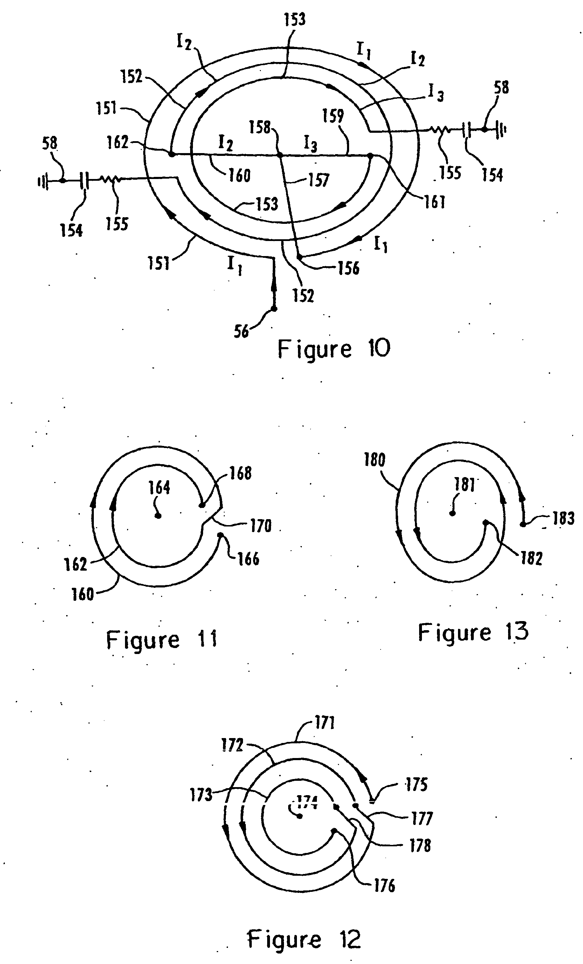

A top view of a further modification is illustrated in Fig. 10 as including outer coil segment 151, connected to a terminal connected to lead 56 and electrically in series with two parallel coil segments 152 and 153, connected by variable impedances 154 to a grounded terminal connected to lead 58. Each of impedances 154 is constructed similarly to and is adjusted to perform the same functions as impedances 132 and 134, described supra in connection with Fig. 7. Each of coil segments 151-153 has an arcuate extent of slightly less than 360° and a different radius $R_8$, $R_9$ and $R_{10}$, of progressively smaller values; in one example $R_8$, $R_9$ and $R_{10}$ are respectively about 26.7, 25 and 24 centimeters for a 25 centimeter radius substrate. End point 156 of coil segment 151, remote from terminal 56, is connected to central, axial terminal 158, in turn connected by radially extending leads 159 and 160 to end points 161 and 162 of coil portions 152 and 153. Magnetic flux resulting from current flowing in leads 157 and 158 is shielded from the gas in chamber 10 by an insulated metal disc as described *supra* for Fig. 7.

The instantaneous currents in adjacent portions of coil segments 151-153 flow in the same directions, causing the magnetic fluxes resulting from these currents to be additive. The current in coil segment 151 has a value equal to twice the separate currents flowing in each of coil portions 152 and 153 to assist in overcoming the flux attenuating properties of can 34. The magnetic flux derived by the coil of Fig. 10 has a minimum value in the center of the coil. The plasma flux in the chamber is relatively constant because of the combined additive effects of the magnetic fluxes resulting from currents flowing in coil segments 151-153 that are considerably closer to can 34 than to lead 158 at the center of the coil.

Reference is now made to Fig. 11 of the drawing, a top view of another embodiment of the invention wherein planar coil 24 includes two circular segments, 160 and 162, respectively having arcuate extents of slightly less than 360° and relatively large radii $R_{11}$ and $R_{12}$ from common central axis 164, that extends through the center of chamber 10 and the processed substrate. Coil segments 160 and 162 respectively include end terminals 166 and 168, connected to leads 56 and 58. The opposite ends of coil segments 160 and 162 are connected to each other by straight, radially and circumferentially extending lead 170. Radii $R_{11}$ and $R_{12}$ are respectively slightly more and slightly less than the radius of the processed substrate.

Coil segments 160 and 162 are arranged so the currents flowing in adjacent sector portions of these two coil segments flow in the same direction to provide additive magnetic fluxes that interact with the gas in chamber 10. The coil formed by segments 160 and 162 is considered to be a circular coil. The value of radius $R_{12}$ is sufficiently large that the currents flowing in opposite directions on opposite sides of axis 164 produce magnetic fluxes that are sufficiently far apart from each other to avoid substantial cancellation effects while still providing a lower magnetic flux in the center of the coil than any other part of the area circumscribed by exterior coil segment 162 . Typically, the minimum value of $R_{11}$ to achieve these results is 5 cm. The combined magnetic fluxes produced by coil segments 160 and 162 are sufficiently great to overcome the tendency of can 34 to attenuate the peripheral portions of the magnetic field. Because of the hollow nature of the coil formed by segments 160 and 162, the magnetic fluxes resulting from current flowing in them are such that the plasma flux is relatively uniform across the entire diameter of the processed substrate.

Fig. 12 is a top view of a further hollow coil embodiment employing three circular segments 171, 172 and 173, respectively spaced from central axis 174, which is coincident with the center of chamber 10 and the processed substrate 32, by radial distances $R_{13}$, $R_{14}$ and $R_{15}$. The values of $R_{13}$, $R_{14}$ and $R_{15}$ are progressively smaller, with the minimum radius, $R_{15}$, being 5 cm. Typically, the processed substrate 32 has a radius of approximately $R_{14}$ (*i.e.* between $R_{13}$ and $R_{15}$), such that coil segment 172 is generally aligned with the periphery of the processed substrate, while coil segments 171 and 173 are respectively slightly outside and slightly inside the periphery of the processed substrate.

Coil segments 171 and 173 include end terminals 175 and 176, respectively connected to leads 56 and 58. The ends of coil segments 171 and 173 opposite from end terminals 175 and 176 are respectively connected to ends of coil segment 173 by radially and circumferentially extending straight leads 177 and 178.

Current flows in adjacent sector portions of coil segments 171, 172 and 173 in the same direction, so the magnetic fluxes derived by these coil segments are additive to overcome the effects of can 34 and provide a relatively uniform plasma flux on the processed substrate. The resulting magnetic field has a minimum value on axis 174 and in the vicinity of the axis and a peak value in the vicinity of coil segment 172. The magnetic flux variation between the center of the hollow coil and underneath coil portion 172, where the flux has a peak value, is such that the plasma flux on the processed substrate is constant to approximately $\pm 2.5$ percent.

The radially and circumferentially extending leads in Figs. 7-12 extend in these two directions, rather than only radially, because such a radial lead would require a right angle bend in conductors carrying relatively large r.f. currents (e.g. tens of amperes). Right angle bends in the coils of Figs. 7-12 are disadvantageous because of the nature of r.f. magnetic field that would result from such a bend. A right angle bend causes a very abrupt change in the r.f. current path. The abrupt current path change has a tendency to produce a large magnetic field, which could have an adverse effect on the uniformity of the magnetic fields and plasma flux in chamber 10.

Reference is now made to Fig. 13, a top view of a hollow coil 180 configured as an equilateral spiral having three turns, with a minimum radius and interior end terminal 182 substantially displaced from central axis 181; axis 181 coincides with the common axes of chamber 10 and the processed substrate. The three turns of coil 180 have average radii of $R_{13}$, $R_{14}$ and $R_{15}$ relative to central axis 181, such that $R_{14}$ equals approximately the radius of the substrate and $R_{13}$ and $R_{15}$ are respectively somewhat smaller and larger than $R_{14}$. End terminals 182 and 183 of spiral coil 180 are respectively connected to leads 56 and 58. End terminal 182 is radially displaced from center axis 181 by an amount slightly less than $R_{13}$, while end terminal 183 is radially displaced from axis 181 by an amount slightly in excess of $R_{15}$. End terminals 182 and 183 lie along approximately the same radial line extending from axis 181. The currents flowing in the three turns of coil 180 produce additive magnetic fluxes in the plasma in chamber 12 such that the magnetic flux is approximately constant in the area of chamber 12 between radii $R_{13}$ and $R_{15}$.

Because of the relatively large separation between end terminal 182 and axis 181 and the relationships of the currents in turns 171-173 there is minimum magnetic flux in the center of the coil of Fig. 13 and the magnetic flux increases to a maximum in a region outside chamber 12 adjacent outer turn 171. Because of the magnetic flux shielding properties of can 34, a substantial portion of the magnetic flux outside chamber 12 and adjacent turn 171 is not coupled to the plasma in chamber 10. The effect is to cause a uniform magnetic field to be coupled to exterior portions of the plasma and a lower magnetic field to be coupled to center portions of the plasma. The plasma flux incident on the workpiece processed surface is substantially uniform because the higher plasma flux in chamber 12 abutting window 18 and somewhat close to the chamber wall diffuses to the center of the chamber. The diffusion occurs because of the differences in plasma flux (plasma density multiplied by plasma particle speed) at the two regions and because of the relative values of (1) the spacing between the workpiece treated surface and the bottom face of window 19 and (2) the diameter of the inner wall of chamber 10.

The spiral coil arrangement of Fig. 13 and the circular coil arrangements of Figs. 11 and 12 can be modified to provide any desired number of turns. In addition, the size of the open area in the center of the coil can be adjusted, as appropriate, to provide the necessary uniformity of the plasma flux incident on the substrate.

The efficiency with which plasma is generated in chamber 10 in response to inductive coupling from the planar sources of Figs. 7-13 depends on the amount of electromagnetic coupling between the plasma r.f. current flowing in the coil and the amplitudes of the r.f. magnetic flux coupled to the plasma. The coupling primarily depends on two factors: (1) the dielectric constant of the materials separating the coil from the plasma, and (2) the separation distance between the coil and plasma.

Because of the transmission line effects of the coils of each of Figs. 7-13, the magnitudes of the r.f. peak-to-peak currents in different portions of the coils vary. A spatially uniform plasma flux is provided in chamber 10 despite the variations of the r.f. currents in the planar coils of Figs. 7-13. The uniform plasma flux is achieved by decreasing electromagnetic coupling between portions of the coils having maximum r.f. peak to peak currents. The differential electromagnetic coupling from the coil portions having maximum and minimum current levels is achieved, in accordance with one aspect of the invention, by tilting the planar coils relative to dielectric window 19.

A planar coil, of the type illustrated in each of Figs. 7-13, that is oriented parallel to dielectric window 19, causes the plasma in chamber 10 to have two non-uniform components, namely: (1) a radial component, f(R), where R is radial distance from the common center of the coil, dielectric window, vacuum chamber and substrate, and (2) an angular component f($\theta$), where $\theta$ is an angle measured relative to a specific radial orientation. In most cases, a pair of mutually orthogonal axes, A and B, can be selected such that the angular dependent plasma non-uniformity, f($\theta$), has a pseudo-linear dependence on axis A, and is approximately independent of axis B. To minimize the angular dependent plasma non-uniformity, the coil is positioned along axis B, so the distance between the plane of the coil and dielectric window 19 is greatest for the region corresponding to the maximum plasma flux. A tilt angle of approximately 9-18° between the planes of the coil and window 19 is believed to produce the most uniform plasma flux.

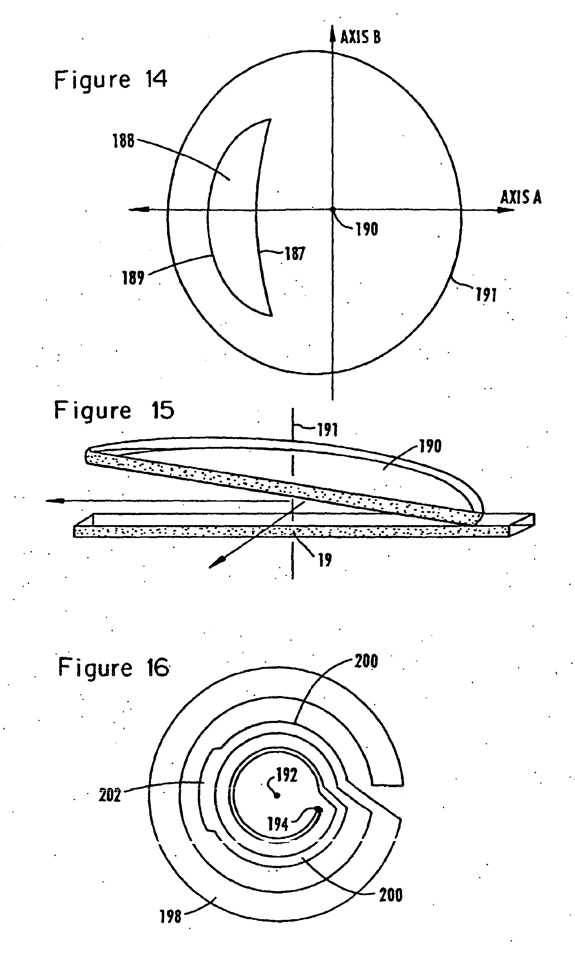

If the planar coils of Figs. 7-13 were located so the plane of the coil were parallel to the plane of window 19, there would be a tendency for the plasma flux in chamber 10 to be a maximum in crescent shaped region 188, Fig. 14. Region 188 includes arcuate edge 189, similar in curvature to a sector of the circumference of a circle, and arcuate edge 187 having a curvature that is much less than that of side 189. Both of edges 187 and 189 are approximately bisected by axis A so region 188 has its greatest width along axis A, which intersects axis B approximately along chamber axis 190.

To overcome this tendency, the planar coil of any of Figs. 7-13 can be tilted upwardly relative to window 19, so a peripheral edge of the coil touches the window at the intersection of axis A and the circumference of circle 191 having a center on axis 190 and a radius such that the circumference of the circle has a curvature appreciably greater than that of edge 189. The diametrically opposite edge of the planar coil is approximately aligned with and is above the intersection of axis A and the circumference of circle 191 opposite from the point on the circle contacting the coil. Since axis A and the planar coil on the side of axis B opposite from area 188 are remote from crescent shaped region 188, the tendency for region 188 to be formed is generally overcome and an approximately uniform plasma flux results on the processed workpiece surface.

A structure for achieving this result is schematically illustrated in perspective in Fig. 15 wherein the plane of planar coil 190, which can have any of the configurations illustrated in Figs. 7-13, is tilted above window 19 by 9° to 18°. Coil 190 is positioned so the places where the current therein has maximum peak-to-peak values are directly above region 188 to reduce the effects of the maximum currents and provide uniformity of plasma flux on the processed substrate.

Another way to provide a magnetic field that produces a plasma having a relatively uniform density while overcoming the effects of can 34 and the variations in magnetic field resulting from the peak-to-peak current variations is to vary the self inductance of the coils of Figs. 7-13 as a function of position along the length of the coil. As is well known, the self inductance of a wire is inversely proportional to the cross sectional area of the wire. An aspect of the present invention relies on this principle to maximize the magnetic field in the periphery of chamber 10, minimize the magnetic field in the center of the chamber and reduce the magnetic field in region 188.

In the embodiment of Fig. 16, this result is attained by arranging spiral coil 192, having the same general configuration as the coil of Fig. 12, so coil 192 has (1) a minimum cross sectional area at and close to interior terminal 194, close to central axis 192, (2) maximum cross sectional area in peripheral portion 198, (3) an average cross sectional area in intermediate portion 200 removed from the coil portion 202 vertically aligned with region 188, and (4) a less than average cross sectional area (greater than the minimum cross sectional area) in coil portion 202 above region 188. This principle can be used as appropriate, in any of the coils of Figs. 2-13. Preferably, the variations in cross sectional area are attained by increasing and decreasing the thickness of a wire lead forming the coil and having a rectangular cross section with a constant width. Other equivalent alternative arrangements can be used, e.g. varying the width of a constant thickness rectangular cross section lead, varying the thickness and width of a rectangular cross section lead or a square cross section lead, or varying the diameter of a circular cross section lead.

A similar effect can be obtained by positioning the coils of Figs. 2-13 in many different planes above window 19 so (1) the coil peripheral portion is closest to the plane of the window, (2) the coil interior terminal and the coil portion closest to it are farther from the plane of the window than any other coil portion, (3) the intermediate coil portion not vertically aligned with region 188 has an average separation from the plane of the window, and (4) the coil portion vertically aligned with region 188 has a separation from the plane of the window between the coil portion farthest from the plane of the window and the average separation between the coil and the window. An obvious disadvantage of this approach, however, concerns difficulties inherent in making and maintaining such coil.

While there have been described and illustrated a specific embodiments of the invention, it will be clear that variations in the details of the embodiment specifically illustrated and described may be made without departing from the scope of the invention as defined in the appended claims.

## Claims

1. A vacuum plasma processor for treating a workpiece (32) in a vacuum chamber (10) including a coil for exciting gas in the processor to a plasma state in response to r.f. energization (26, 28) of the coil, the coil having plural substantially coaxial turns spaced by different radii from a common center point of the coil (44, 46, 48, 162, 160; 171, 172, 173) adapted to be reactively coupled to the gas for exciting gas in the processor to a plasma state in response to r.f. energization (26, 28) of the coil, the turns of the coil being arranged so that the coil extends radially outward from an interior turn (173) to an exterior turn (171), the plural turns having adjacent ends lying along different radii from the common center point, adjacent ends of each pair of radially adjacent different turns being connected to each other by a substantially straight lead (82, 78, 72; 170; 177, 178) **characterised in that** said lead along a direction which is not only radial with respect to the common center point but also circumferential with respect to the substantially coaxial turns.

2. A vacuum plasma processor as claimed in claim 1 wherein a source of the r.f. energization (26, 28) is connected to first and second terminals of the coil such that the magnitude of the peak-to-peak r.f. voltage has a maximum value with a first polarity at the first terminal of the coil and a maximum value with a second polarity at the second terminal of the coil.

3. A vacuum plasma processor as claimed in claim 1 or claim 2 wherein the coil includes several arcuate segments having an arcuate extent of about one turn, including an outermost arcuate segment (48) having an arcuate extent of about one turn and a next outermost arcuate segment (46) having an arcuate extent of about a turn, the r.f. energization being connected to the coil and the coil being configured such that r.f. current in the outermost arcuate segment and the next outermost arcuate segment is substantially greater than current in an interior segment of the coil.

4. A vacuum plasma processor as claimed in claim 1, 2 or 3, wherein a source of the r.f. energization (26, 28) is connected to first and second terminals (52, 54) of the coil and the coil is such that the magnitude of peak-to-peak r.f. current at the first terminal is approximately equal to the peak-to-peak r.f. current at the second terminal.

5. A vacuum plasma processor as claimed in claim 4 wherein the equal currents at the first and second terminals have amplitudes lower than any other currents in the coil.

6. A vacuum plasma processor of any of claims 1 to 5 wherein first and second excitation terminals of the coil (52, 54) are located in a center region of the coil.

7. A vacuum plasma processor of claim 6 wherein the first and second excitation terminals are respectively connected to first and second arcuate segments (40, 42) having an arcuate extent of about one half a turn, the arcuate segments having about the same dimensions and arranged substantially concentrically such that the first and second terminals are located next to each other.

8. A vacuum plasma processor of claim 7 wherein the innermost arcuate segments (40, 42) are located on diametrically opposite sides of a centerline which cuts the coil in half, the coil being arranged and connected to the r.f. excitation source so instantaneous r.f. voltages at the first and second excitation terminals (52, 54) have substantially equal magnitude but are of opposite polarity.

9. A vacuum plasma processor of any of claims 7 to 8 wherein an outermost arcuate turn (48) of the coil is connected to the one inner segment by a straight length of conductive strap (64) electrically insulated from the coil except at its ends.


**Patentansprüche**

1. Vakuumplasmabearbeitungsvorrichtung zur Bearbeitung eines Werkstücks (32) in einer Vakuumkammer (10) mit einer Spule zur Erregung von Gas in der Bearbeitungsvorrichtung in einem Plasmazustand in Abhängigkeit von der RF-Erregung (26, 28) der Spule, wobei die Spule mehrere im wesentlichen koaxiale Wicklungen hat, die durch verschiedene Radien von einem gemeinsamen Mittelpunkt der Spule (44, 46, 48; 162, 160; 171, 172, 173) getrennt sind und reaktionsmäßig mit dem Gas zur Erregung des Gases in der Bearbeitungsvorrichtung koppelbar sind, und zwar zur Erreichung eines Plasmazustandes in Abhängigkeit von der RF-Erregung (26, 28) der Spule, wobei ferner die Wicklungen der Spule so angeordnet sind, daß sich die Spule radial von einer inneren Wicklung (173) zu einer äußeren Wicklung (171) erstreckt, und wobei die vielen Wicklungen benachbarte Enden aufweisen, die längs verschiedener Radien von dem gemeinsamen Mittelpunkt aus liegen und wobei benachbarte Enden der radial nebeneinander liegenden unterschiedlichen Wicklungen miteinander durch eine im wesentlichen gerade Leitung (82, 78, 72; 170; 177, 178) verbunden sind, **dadurch gekennzeichnet, daß** sich die Leitung längs einer Richtung erstreckt, die nicht nur in Bezug auf den gemeinsamen Mittelpunkt radial ist, sondern auch in Bezug auf die im wesentlichen koaxialen Wicklungen umfänglich.

2. Vakuumplasmabearbeitungsvorrichtung nach Anspruch 1, **dadurch gekennzeichnet, daß** eine Quelle der RF-Erregung (26, 28) mit den ersten und zweiten Endklemmen der Spule so verbunden ist, daß die Höhe der RF-Spannung von Peak-zu-Peak einen Maximalwert aufweist, mit einer ersten Polarität an der ersten Endklemme der Spule und einem Maximalwert mit einer zweiten Polarität an der zweiten Endklemme der Spule.

3. Vakuumplasmabearbeitungsvorrichtung nach Anspruch 1 oder 2, **dadurch gekennzeichnet, daß** die Spule mehrere bogenförmige Segmente aufweist, die eine Bogenlänge von etwa einer Wicklung haben, einschließlich eines äußersten Bogensegments (48), das eine Bogenlänge von etwa einer Wick-Wicklung hat sowie eines folgenden äußeren Bogensegments (46), das eine Bogenlänge von etwa einer Wicklung hat, wobei die RF-Erregung mit der Spule verbunden ist und die Spule so ausgebildet ist, daß der RF-Strom in dem äußersten Bogensegment und dem nächstäußersten Bogensegment erheblich größer ist als der Strom in einem inneren Segment der Spule.

4. Vakuumplasmabearbeitungsvorrichtung nach Anspruch 1, 2 oder 3, **dadurch gekennzeichnet, daß** eine Quelle der RF-Erregung mit einer ersten und einer zweiten Endklemme (52, 54) der Spule verbunden ist, und daß die Spule so geartet ist, daß die Höhe des Peak-zu-Peak-RF-Stroms an der ersten Endklemme nahezu gleich dem Peak-zu-Peak-RF-Strom an der zweiten Endklemme ist.

5. Vakuumplasmabearbeitungsvorrichtung nach Anspruch 4, **dadurch gekennzeichnet, daß** die gleichen Ströme an den ersten und zweiten Endklemmen Amplituden aufweisen, die niedriger sind als irgendwelche anderen Ströme in der Spule.

6. Vakuumplasmabearbeitungsvorrichtung nach einem der Ansprüche 1 bis 5, **dadurch gekennzeichnet, daß** die ersten und zweiten Erregerendklemmen der Spule (52, 54) in einem Mittelbereich der Spule angeordnet sind.

7. Vakuumplasmabearbeitungsvorrichtung nach Anspruch 6, **dadurch gekennzeichnet, daß** die ersten und zweiten Erregerendklemmen getrennt mit den ersten bzw. zweiten Bogensegmenten (40, 42) verbunden sind, welche eine Bogenlänge von etwa einer halben Wicklung aufweisen, und daß die Bogensegmente etwa dieselben Abmessungen besitzen und im wesentlichen konzentrisch angeordnet sind, so daß die ersten und zweiten Endklemmen einander am nächsten liegen.

8. Vakuumplasmabearbeitungsvorrichtung nach Anspruch 7, **dadurch gekennzeichnet, daß** die innersten bogenförmigen Segmente (40, 42) auf diametral gegenüberliegenden Seiten einer Mittellinie angeordnet sind, die die Spule halbiert, wobei die Spule so angeordnet und an die RF-Erregungsquelle angeschlossen ist, daß momentane RF-Spannungen an den ersten und zweiten Erregerendklemmen (52, 54) im wesentlichen die gleiche Höhe, jedoch entgegengesetzte Polarität haben.

9.  Vakuumplasmabearbeitungsvorrichtung nach einem der Ansprüche 7 bis 8, **dadurch gekennzeichnet, daß** die äußerste gebogene Wicklung (48) der Spule mit einem inneren Segment durch eine gerade Länge des Leiterstreifens (64) verbunden ist, der elektrisch von der Spule, ausgenommen an seinen Enden, isoliert ist.

**Revendications**

1.  Processeur à plasma sous vide pour traiter une pièce à usiner (32) dans une chambre sous vide (10) incluant une bobine pour exciter le gaz dans le processeur à un état de plasma en réponse à une alimentation r.f. (26, 28) de la bobine, la bobine ayant de multiples spires sensiblement coaxiales espacées de différents rayons depuis un point central commun de la bobine (44, 46, 48; 162, 160; 171, 172, 173) adaptées à être couplées de manière réactive au gaz pour exciter le gaz dans le processeur à un état de plasma en réponse à une alimentation r.f. (26, 28) de la bobine, les spires de la bobine étant agencées de sorte que la bobine s'étend radialement vers l'extérieur depuis une spire intérieure (173) vers une spire extérieure (171), les spires multiples ayant des extrémités adjacentes disposées le long de différents rayons depuis le point central commun, des extrémités adjacentes de chaque paire de différentes spires radialement adjacentes étant connectées l'une à l'autre par un conducteur sensiblement droit (82, 78, 72; 170; 177, 178), **caractérisé en ce que** ledit conducteur s'étend le long d'une direction qui est non seulement radiale par rapport au point central commun mais aussi périphérique par rapport aux spires sensiblement coaxiales.

2.  Processeur à plasma sous vide comme revendiqué dans la revendication 1, dans lequel une source de l'alimentation r.f. (26, 28) est connectée à des crémière et deuxième bornes de la bobine de sorte que l'amplitude de la tension r.f. crête-à-crête a une valeur maximale avec une première polarité à la première borne de la bobine et une valeur maximale avec une deuxième polarité à la deuxième borne de la bobine.

3.  Processeur à plasma sous vide comme revendiqué dans la revendication 1 ou la revendication 2, dans lequel la bobine inclut plusieurs segments arqués ayant une étendue arquée d'une spire environ, incluant un segment arqué le plus extérieur (48) ayant une étendue arquée d'une spire environ et un segment arqué le plus extérieur suivant (46) ayant une étendue arquée d'une spire environ, l'alimentation r.f. étant connectée à la bobine et la bobine étant configurée de sorte que le courant r.f. dans le segment arqué le plus extérieur et dans le segment arqué le plus extérieur suivant est sensiblement supérieur au courant dans un segment intérieur de la bobine.

4.  Processeur à plasma sous vide comme revendiqué dans la revendication 1, 2 ou 3, dans lequel une source de l'alimentation r.f. (26, 28) est connectée aux première et deuxième bornes (52, 54) de la bobine et la bobine est telle que l'amplitude du courant r.f. crête-à-crête à la première borne est approximativement égale au courant r.f. crête-à-crête à la deuxième borne.

5.  Processeur à plasma sous vide comme revendiqué dans la revendication 4, dans lequel les courants égaux dans les première et deuxième bornes ont des amplitudes inférieures à tout autre courant dans la bobine.

6.  Processeur à plasma sous vide selon l'une quelconque des revendications 1 à 5, dans lequel les première et deuxième bornes d'excitation de la bobine (52, 54) sont situées dans une zone centrale de la bobine.

7.  Processeur à plasma sous vide selon la revendication 6, dans lequel les première et deuxième bornes d'excitation sont respectivement connectées à des premier et deuxième segments arqués (40, 42) ayant une étendue arquée d'une moitié de spire environ, les segments arqués ayant environ les mêmes dimensions et étant agencés de manière sensiblement périphérique de sorte que les première et deuxième bornes sont situées l'une à côté de l'autre.

8.  Processeur à plasma sous vide selon la revendication 7, dans lequel les segments arqués les plus intérieurs (40, 42) sont situés sur des côtés diamétralement opposés d'une ligne centrale qui sectionne la bobine en deux, la bobine étant agencée et connectée à la source d'excitation r.f. de sorte que des tensions r.f. instantanées aux première et deuxième bornes d'excitation (52, 54) ont une amplitude sensiblement égale mais sont de polarité opposée.

9.  Processeur à plasma sous vide selon l'une quelconque des revendications 7 à 8, dans lequel une spire arquée la plus extérieure (48) de la bobine est connectée au segment intérieur par une longueur droite de lien conducteur (64) isolée électriquement de 1a bobine à l'exception de ses extrémités.

Figure 1

Figure 2A

Figure 2B

EP 1 204 134 B1

Figure 3

Figure 4

Figure 5A

Figure 5B

Figure 6

Figure 7

Figure 8

Figure 9

Figure 10

Figure 11

Figure 13

Figure 12

Figure 14

AXIS B

188

189

187

190

AXIS A

191

Figure 15

191

190

19

Figure 16

200

192

202

194

200

198

23

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4948458 A, Ogle
- US 5304279 A, Coultas
- US 5433812 A, Cuomo

- US 5277751 A, Ogle
- US 5226967 A, Chen

**Non-patent literature cited in the description**

- **FUKUSAWA et al.** RF Self-Bias Characteristics in Inductively Coupled Plasma. *Japanese Journal of Applied Physics,* December 1993, vol. 32 (12(B), 6076-6079